# FASCICULE DE BREVET EUROPEEN

(11) **EP 2 782 119 B1**
(45) Date de publication et mention de la délivrance du brevet: **31.03.2021**
(21) Numéro de dépôt: 14160802.6
(22) Date de dépôt: 20.03.2014
(51) Int. Cl.: H01L 21/20, H01L 21/8238, H01L 21/265

(54) **PROCÉDÉ DE MODIFICATION LOCALISÉE DES CONTRAINTES DANS UN SUBSTRAT DU TYPE SOI, EN PARTICULIER FD SOI, ET DISPOSITIF CORRESPONDANT**
VERFAHREN ZUR LOKALISIERTEN VERÄNDERUNG DER SPANNUNGEN IN EINEM SUBSTRAT VOM TYP SOI, INSBESONDERE FDSOI, UND ENTSPRECHENDE VORRICHTUNG
METHOD FOR LOCALLY MODIFYING THE STRAINS IN A SOI SUBSTRATE, IN PARTICULAR A FD SOI SUBSTRATE AND CORRESPONDING DEVICE

(30) Priorité: 21.03.2013 FR 1352535
(43) Date de publication de la demande: 24.09.2014
(73) Titulaire: STMicroelectronics (Crolles 2) SAS, 38920 Crolles (FR); COMMISSARIAT À L'ÉNERGIE ATOMIQUE ET AUX ÉNERGIES ALTERNATIVES, 75015 Paris (FR)
(72) Inventeur: Boeuf, Frédéric, 38420 LE VERSOUD (FR); Weber, Olivier, 38000 GRENOBLE (FR)
(74) Mandataire: Casalonga

(56) Documents cités:
- US-A1- 2005 116 290
- US-A1- 2007 281 446
- US-A1- 2009 108 301

## Description

L'invention concerne les circuits intégrés, et notamment les substrats du type silicium sur isolant (SOI : Silicon On Insulator), plus particulièrement les substrats du type silicium sur isolant totalement désertés (FD SOI : Fully Depleted Silicon On Insulator), partiellement contraints en vue de la co-intégration de transistors NMOS et PMOS.

Lorsqu'un transistor NMOS présente un canal contraint en tension, la mobilité des porteurs augmente de même que le courant débité ce qui augmente ses performances. Par contre, un canal contraint en tension dégrade les performances d'un transistor PMOS notamment au niveau de la mobilité des trous qui diminue.

Il existe aujourd'hui, dans des technologies dites « substrat massif », des techniques pour contraindre en tension les canaux des transistors NMOS.

Il existe également des substrats du type SOI dans lesquels le film de silicium, qui repose sur la couche isolante enterrée supportée par un substrat support de silicium, par exemple un caisson, est déjà contraint en tension. Mais, si cela est avantageux pour la réalisation des transistors NMOS, cela présente un inconvénient pour la réalisation des transistors PMOS.

Le document US2007/281446 A1 décrit une technique fournissant un substrat hybride planarisé en exposant une couche d'oxyde enterrée dans une première zone, en gravant sélectivement la couche d'oxyde enterrée pour exposer une première couche semi-conductrice dans une seconde zone de germe plus petite. Une croissance épitaxiale d'un premier matériau semiconducteur épitaxié à partir de la zone de germe remplit la seconde ouverture et se développe latéralement sur la couche isolante exposée pour remplir au moins une partie de la première ouverture, formant ainsi une première couche semi-conductrice épitaxiée, qui est par ailleurs électriquement isolée de la deuxième couche semi-conductrice.

L'invention est définie par les revendications indépendantes annexées. Des modes de réalisation et de mise en œuvre préférés sont contenus dans les revendications dépendantes.

Selon un mode de mise en œuvre, il est proposé de modifier de façon locale les contraintes dans un substrat du type SOI initialement contraint en tension de façon à pouvoir y réaliser des transistors PMOS, et ce d'une façon compatible avec des films minces tels que ceux utilisés dans la technologie FD SOI.

Selon un mode de mise en œuvre, il est également proposé de rendre contraintes en compression, les parties du film semi-conducteur dans lesquelles seront réalisés les transistors PMOS.

Selon un mode de mise en œuvre, il est aussi proposé de relâcher les contraintes d'une zone de silicium initialement contrainte en tension indépendamment de l'orientation cristallographique de ladite zone de silicium.

Selon un mode de mise en œuvre il est aussi proposé de former une zone de film semiconducteur contraient en compression de façon à améliorer les performances d'un transistor PMOS réalisé dans une telle zone de film, indépendamment de l'orientation cristallographique du film semiconducteur.

Selon un aspect, il est proposé un procédé de modification localisé des contraintes dans un substrat du type silicium sur isolant initialement contraint en tension ; un tel substrat comprend un film semi-conducteur de silicium initialement contraint en tension disposé sur une couche isolante dite enterrée elle-même disposée sur un substrat support de silicium non contraint ;
le procédé comprend
une formation d'au moins une ouverture dans le film de silicium initialement contraint et dans la couche isolante enterrée sous-jacente jusqu'à atteindre le substrat support de silicium non contraint,
une épitaxie de silicium dans ladite au moins une ouverture à partir substrat support de silicium non contraint de façon à combler ladite au moins une ouverture,
une amorphisation localisée d'une zone du film de silicium incluant ladite au moins une zone épitaxiée,
une recristallisation de ladite au moins une zone amorphisée par une épitaxie en phase solide à partir de la partie de silicium non contraint située dans ladite au moins une ouverture et en contact avec la zone amorphisée,
de façon à obtenir dans le film de silicium contraint au moins une zone localisée de film comportant du silicium relâché en tension.

Ainsi, selon cet aspect, l'obtention de la zone localisée de silicium relâché en tension est obtenue par la combinaison d'une amorphisation localisée d'une zone du film de silicium et d'une recristallisation de cette zone à partir d'un germe de silicium qui se situe sous cette zone amorphisée, et plus précisément dans la partie de l'ouverture comblée par épitaxie située entre des portions de la couche isolante enterrée, indépendamment de l'orientation cristallographique de ladite zone de silicium et sans forcément changer l'orientation cristallographique de ladite zone.

Et, ceci est particulièrement intéressant pour des technologies SOI dans lesquelles le film de silicium peut être relativement fin, et tout particulièrement dans les technologies FD SOI dans lesquelles le film de silicium est particulièrement fin, typiquement de l'ordre de quelques nanomètres. En effet, dans ce cas, l'amorphisation localisée du film conduit à une amorphisation dans toute la profondeur et il est donc à ce moment-là nécessaire d'avoir sous cette zone amorphisée, un germe de silicium au contact de cette zone amorphisée pour permettre la recristallisation par épitaxie en phase solide.

Une technologie FD SOI offre des propriétés de faible consommation et de fonctionnement à très basse tension d'alimentation. Par ailleurs, dans le substrat support de silicium (un caisson par exemple) il est prévu de disposer des régions d'électrodes de commande enterrées, sous la couche isolante enterrée (BOX) de façon à pouvoir polariser également les canaux des transistors MOS réalisés dans le film semi-conducteur. Et, ces régions d'électrodes enterrées sont polarisées par l'intermédiaire de puits de contact reliant les caissons à la face supérieure du film.

Et, selon un mode de mise en œuvre, chaque ouverture qui va permettre la recristallisation de la zone amorphisée correspondante, correspond à un puits destiné à permettre le contact avec substrat support de silicium (caisson par exemple).

En d'autres termes, on peut avantageusement utiliser, pour définir des emplacements desdites ouvertures, le même masque que celui destiné à définir les emplacements de ces puits de contact. Il en résulte par conséquent une mise en œuvre simplifiée du procédé.

Selon un mode de mise en œuvre, il est en outre particulièrement avantageux de former un alliage de silicium-germanium dans au moins une partie de ladite zone localisée relâchée en tension de façon à former une zone de film contraint en compression. Ceci va permettre d'améliorer encore les performances d'un transistor PMOS qui sera réalisé dans une telle zone de film comprimée.

Selon un autre aspect, il est également proposé un procédé de réalisation de transistor du type à canal N et de transistor de type à canal P, par exemple des transistors NMOS et PMOS, dans un substrat de type silicium sur isolant initialement contraint, comprenant une réalisation des transistors à canal P dans ladite au moins une zone localisée de silicium relâchée en tension obtenue par le procédé défini ci-avant ou dans la zone de film contrainte en compression obtenue par le procédé défini ci-avant, et une réalisation des transistors à canal N dans la ou les zones de film comportant du silicium contraint en tension.

Selon un autre aspect, il est proposé un dispositif comprenant un substrat du type silicium sur isolant, ledit substrat comportant un film semi-conducteur disposé sur une couche isolante dite enterrée elle-même disposée sur un substrat support de silicium non contraint, le film semi-conducteur comprenant au moins une première zone de film comportant du silicium contraint en tension et au moins une deuxième zone de film comportant du silicium relâché en tension, ladite couche isolante enterrée comportant au moins une ouverture sous ladite au moins une deuxième zone de film, ladite ouverture comportant du silicium non contraint.

Le substrat peut être avantageusement du type silicium sur isolant totalement déserté.

Par ailleurs, selon un mode de réalisation, au moins une partie de ladite au moins une deuxième zone de film peut comprendre un alliage de silicium-germanium de façon à former une partie de film contraint en compression.

Le dispositif peut ainsi comprendre au moins un transistor NMOS réalisé dans et sur ladite au moins une première zone de film et au moins un transistor PMOS réalisé dans et sur ladite deuxième zone de film.

D'autres avantages et caractéristiques de l'invention apparaîtront à l'examen de la description détaillée de modes de mise en œuvre et de réalisation, nullement limitative, et des dessins annexés sur lesquels :

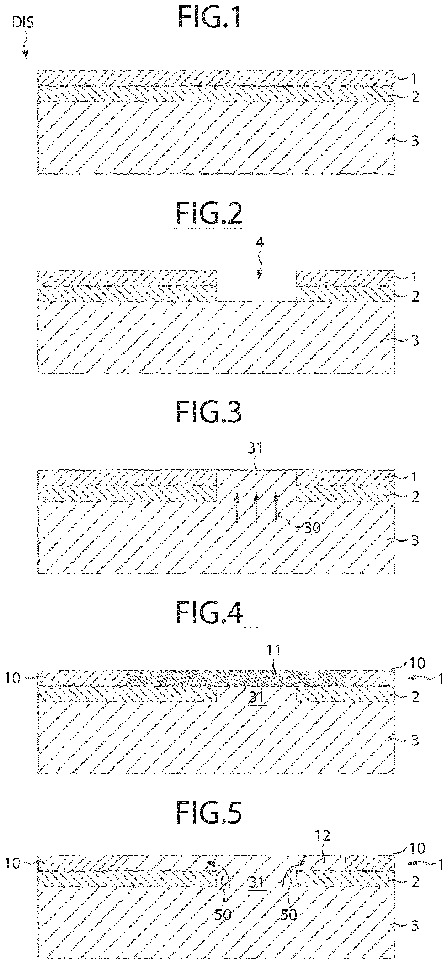

- les figures 1 à 16 ont trait à différents modes de mise en œuvre du procédé selon l'invention et de réalisation d'un dispositif selon l'invention.

Sur la figure 1, la référence DIS désigne un dispositif, par exemple une plaquette semi-conductrice (wafer) comportant une région inférieure, ou substrat support, 3 de silicium non contraint. Cette région 3 peut être par exemple un caisson.

Cette région 3 peut généralement comprendre du silicium intrinsèque, c'est-à-dire non dopé. Cela étant, en pratique, il existe toujours un faible taux de dopants mais, lorsque ce taux de dopants est inférieur à 10¹⁵ atomes par cm3, on parle alors néanmoins de silicium intrinsèque.

Cette région inférieure 3 de silicium est surmontée par une couche isolante enterrée 2 communément désignée par l'homme du métier sous la dénomination anglo-saxonne de « BOX ». Cette région isolante peut être par exemple formée de dioxyde de silicium.

Au-dessus de cette couche isolante enterrée, se situe un film semi-conducteur 1 formé ici de silicium contraint en tension. On voit donc ici que le film 1 fait partie d'un substrat du type silicium sur isolant.

Dans une technologie FD SOI, l'épaisseur de ce film 1 est de l'ordre de quelques nanomètres. Et, c'est dans ce film 1 que vont être réalisés des transistors NMOS et PMOS.

On va maintenant décrire en se référant plus particulièrement aux figures 2 à 5, un mode de mise en œuvre du procédé permettant de relâcher localement les contraintes en tension dans le film semi-conducteur 1.

A cet égard, comme illustré sur la figure 2, on forme dans le film 1 un orifice ou une ouverture 4, typiquement par une opération classique de gravure, qui se prolonge dans la couche isolante enterrée 2 pour déboucher sur la région inférieure 3 de silicium non contraint.

On procède ensuite (figure 3) à une épitaxie classique et connue en soi 30 de silicium de façon à venir combler l'ouverture 4 par du silicium qui est cette fois-ci non contraint car ayant crû depuis la région 3 de silicium non contraint.

On procède ensuite (figure 4) à une amorphisation localisée du film 1 dans une zone contenant au moins une partie de l'ouverture avec le silicium épitaxié, de façon à former une zone amorphisée 11 au contact du silicium épitaxié ayant comblé ladite ouverture. La définition de l'emplacement de cette zone s'effectue de façon classique par un masque et l'amorphisation comprend, de façon classique, un bombardement de la zone de silicium correspondante par des atomes, par exemple de l'argon ou du germanium.

A l'issue de cette amorphisation, le film 1 comporte par conséquent une zone amorphisée localisée 11 qui est en contact avec le silicium non contraint 31 résultant de l'épitaxie 30 et situé entre les portions de couche isolante 2.

Le film 1 comporte également de part et d'autre de cette zone amorphisée 11 une zone de film 10 formée de silicium contraint en tension.

L'étape suivante (figure 5) comprend une recristallisation de la zone amorphisée 11 par une épitaxie en phase solide 50. Une telle épitaxie est connue par l'homme du métier sous l'acronyme anglo-saxon de « SPER » (« Solide Phase Epitaxy Regrowth »).

Une telle épitaxie est obtenue à partir du germe de silicium non contraint 31 par chauffage, typiquement entre 400 et 1000°C pendant une durée pouvant varier entre une minute et une heure selon le volume de la zone amorphisée à recristalliser. L'homme du métier pourra à toutes fins utiles se référer, en ce qui concerne notamment des ordres de grandeurs des vitesses de recristallisation du silicium amorphisé à l'article suivant : « Substrate-orientation dependence of the epitaxial regrowth rate from Si-implanted amorphous Si », L. Csepregi et al, J. Appl. Phys. 49(7), pp 3906-3911, July 1978 .

A l'issue de cette recristallisation, le film 1 comporte une zone localisée 12 de film comportant du silicium relâché en tension, et une zone de film 10 comportant du silicium contraint en tension.

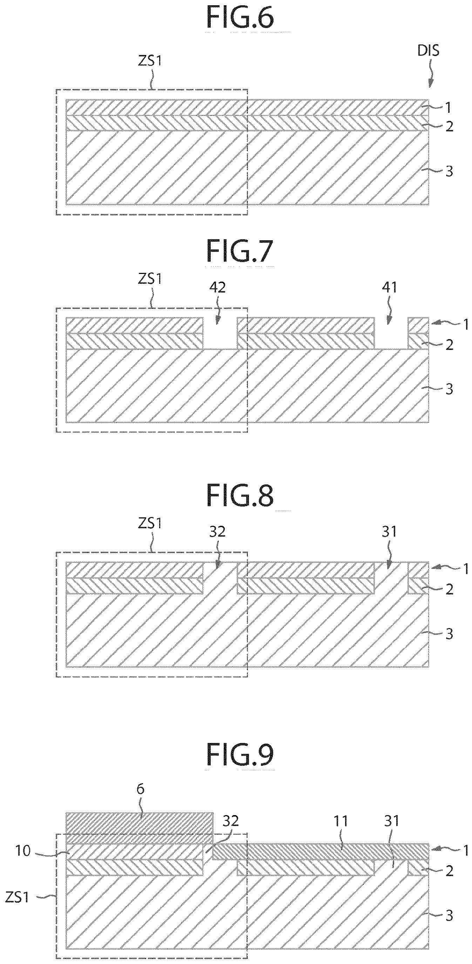

On se réfère maintenant plus particulièrement aux figures 6 à 12 pour décrire une application de l'invention à la co-intégration de transistors NMOS et de transistors PMOS dans un substrat du type FD SOI.

Plus précisément, comme illustré sur la figure 6, on souhaite réaliser les transistors NMOS dans la zone ZS1 du film 1 initialement contraint en tension et les transistors PMOS à l'extérieur de cette zone ZS1.

On procède alors (figure 7) à la réalisation de deux ouvertures ou orifices 41 et 42 dans le film 1 et la couche isolante enterrée 2 débouchant dans la région inférieure de silicium (substrat support) 3, d'une façon analogue à ce qui a été décrit en référence à la figure 2. Il convient de noter ici que l'emplacement de ces deux ouvertures correspond aux deux emplacements des futurs puits de contact qui vont permettre de contacter le caisson inférieur 3 à partir de la face avant de façon à venir polariser les électrodes enterrées respectives qui seront formées par implantation sous la couche isolante 2.

On procède ensuite, d'une façon analogue à ce qui a été décrit en référence à la figure 3, à une épitaxie de silicium à partir de la région 3 de façon à venir combler les ouvertures 41 et 42 avec du silicium non contraint 31 et 32 (figure 8).

Puis, comme illustré sur la figure 9, on masque la zone de silicium contraint 10 du film 1, destiné à recevoir le ou les transistors NMOS, avec un bloc de résine 6 avant de procéder à l'amorphisation localisée du reste du film 1.

On obtient donc une zone amorphisée 11 en contact notamment avec le silicium non contraint 31.

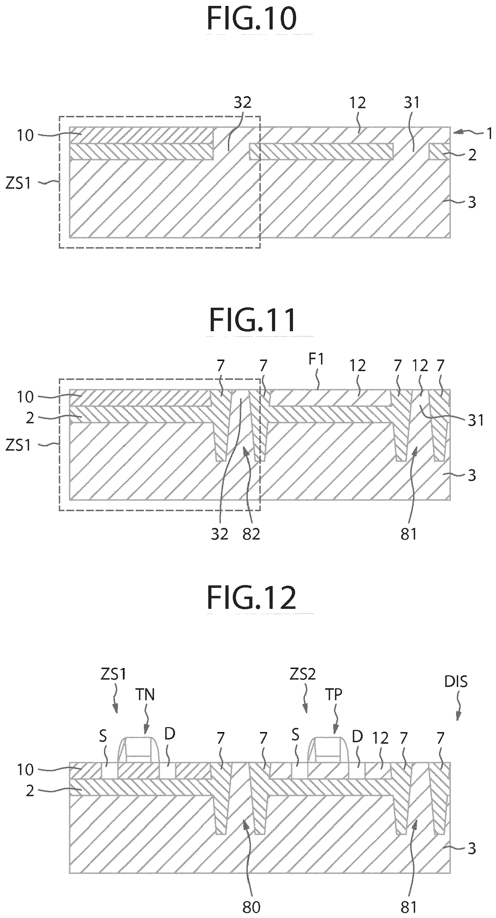

On procède ensuite (figure 10) à une recristallisation de la zone amorphisée 11 à partir notamment du silicium non contraint 31 de façon à former une zone localisée 12 de film comportant du silicium relâché en tension.

On procède ensuite à la réalisation classique de zones d'isolation 7 du type tranchées peu profondes par exemple (en anglais STI), de façon à isoler électriquement les zones de film 10 et 12 et à délimiter les puits de contact 81 et 82 (figure 11) qui vont permettre la polarisation des électrodes enterrées (non représentées ici à des fins de simplification) depuis une face supérieure F1 du film 1.

Comme illustré sur la figure 12, un ou plusieurs transistors NMOS TN sont réalisés dans la zone de film 10 comportant du silicium contraint en tension, les régions de source S et de drain D du ou des transistors étant réalisées par une epitaxie suivie d'une implantation de dopants, ou par une épitaxie de semi-conducteur (par exemple Silicium) dopée in-situ (par exemple Carbone ou Phosphore).

Par ailleurs, le ou les transistors PMOS TP sont réalisés dans la zone de silicium relâchée en contrainte de tension 12. De la même façon que pour le NMOS TN, les régions de source S et drain D seront réalisé par implantation de dopants, ou par une épitaxie de semi-conducteur (par exemple Silicium ou Silicium Germanium) dopée in-situ (par exemple Bore).

Bien entendu si la région 11 de silicium amorphisée est trop longue, il se peut que la recristallisation de cette zone soit incomplète. Dans ce cas on prévoira au préalable plusieurs orifices de « germination», sous cette grande zone amorphisée ce qui va conduire in fine à plusieurs zones 12 séparées par des puits de contact, dans lesquelles seront réalisés les transistors PMOS..

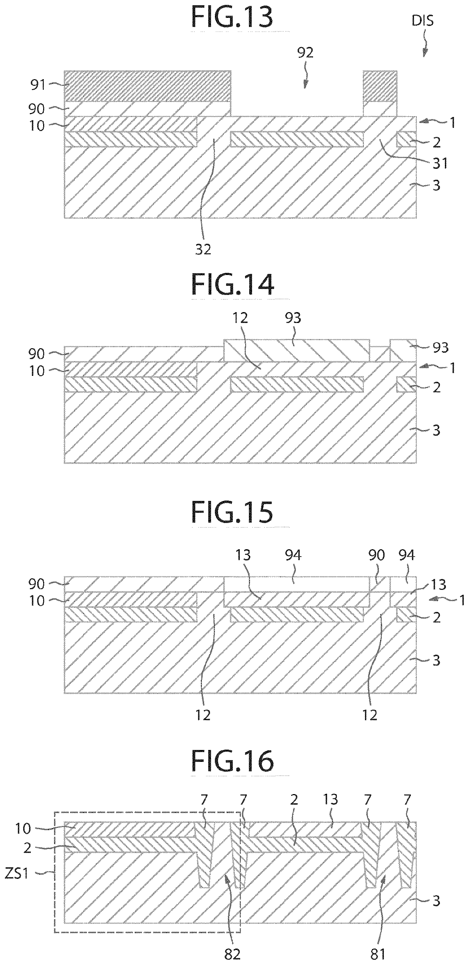

Les figures 13 à 16 illustrent schématiquement une autre mise en œuvre de l'invention prévoyant cette fois-ci la réalisation d'une zone localisée de film contraint en compression.

Plus précisément, sur la structure illustrée sur la figure 10, on dépose une couche de masque dur 90 ainsi qu'un bloc de résine 91.

On délimite ensuite par masquage, l'emplacement d'un orifice ou d'une ouverture 92 permettant de dégager la partie de la zone 12 de silicium relâchée en tension dans laquelle vont être réalisés les transistors PMOS.

On fait croître ensuite (figure 14) une couche 93 d'un alliage de silicium germanium. Une telle étape d'épitaxie de SiGe est classique et connue en soi. Puis, on procède à une étape de condensation de ce silicium germanium conduisant à une oxydation surfacique du silicium germanium et à une diffusion des atomes de germanium dans la couche de silicium sous jacente 12.

Une telle étape de condensation, classique et connue en soi, s'effectue en chauffant le silicium germanium épitaxié par exemple à une température de 900°C à 1100°C pendant une durée de l'ordre de la seconde à quelques minutes.

A l'issue de cette étape de condensation, le dispositif DIS comporte une couche de silicium germanium contraint en compression surmonté d'une couche de dioxyde de silicium 94 (figure 15).

On procède ensuite (figure 16) à un retrait du masque dur 90 et de la couche de dioxyde de silicium 94 par un nettoyage classique, par exemple à l'aide d'acide fluorhydrique.

Après réalisation des tranchées isolantes 7, on obtient donc un dispositif comportant dans la zone ZS1 un film de silicium contraint en tension 10 dans laquelle va pouvoir être réalisé le ou les transistors NMOS ainsi qu'un film 13 en silicium germanium contraint en compression, dans lequel va pouvoir être réalisé le ou les transistors PMOS.

Il convient de noter qu'une zone contrainte en tension (resp. en compression) dans le plan du substrat est contrainte en compression (resp en tension) dans une direction perpendiculaire. Une zone ne peut pas être contrainte en tension et en compression suivant la même direction.

## Revendications

1. Procédé de réalisation de transistors du type à canal N et de transistors du type à canal P dans un substrat du type silicium sur isolant totalement déserté initialement contraint en tension comprenant un film (1) semi-conducteur de silicium initialement contraint en tension disposé sur une couche isolante (2) dite enterrée elle-même disposée sur un substrat support de silicium (3) non contraint, le procédé comprenant une modification localisée des contraintes comprenant :
une formation d'au moins une ouverture (4) dans le film (1) semi-conducteur de silicium initialement contraint et dans la couche isolante enterrée sous-jacente (2) jusqu'à atteindre le substrat (3) de silicium non contraint, ladite ouverture (41) étant formée au niveau d'un puits (81) destiné à permettre un contact avec le substrat support de silicium depuis la face supérieure du film (1) semi-conducteur de silicium initialement contraint,
une épitaxie (30) de silicium dans ladite au moins une ouverture (4) à partir du substrat support (3) de silicium non contraint de façon à combler ladite au moins une ouverture, formant au moins une zone de silicium épitaxié non contraint (31),
une amorphisation localisée d'une zone dudit film semi-conducteur de silicium initialement contraint incluant ladite au moins une zone de silicium épitaxié non contraint (31), formant au moins une zone amorphisée (11), et
une recristallisation de ladite au moins une zone amorphisée (11) par une épitaxie en phase solide (50) à partir de la partie de ladite au moins une zone silicium épitaxié non contraint (31) située dans ladite au moins une ouverture et en contact avec ladite au moins une zone amorphisée (11), de façon à obtenir dans le film (1) semi-conducteur de silicium initialement contraint au moins une zone localisée de film (12) comportant du silicium relâché en tension,
une réalisation de zones d'isolation (7), de façon à isoler électriquement des zones (10) du film (1) semi-conducteur de silicium initialement contraint comportant du silicium contraint en tension et ladite au moins une zone localisée de film (12) comportant du silicium relâché en tension, et à délimiter ledit puits (81),
le procédé comprenant en outre :
une réalisation des transistors à canal P dans ladite au moins une zone localisée de silicium relâché en tension (12), et
une réalisation des transistors à canal N dans les zones (10) du film (1) semi-conducteur de silicium initialement contraint comportant du silicium contraint en tension.

2. Procédé selon la revendication 1, dans lequel ladite modification localisée des contraintes comprend en outre une formation d'un alliage de silicium germanium (13) dans au moins une partie de ladite zone localisée relâchée en tension, de façon à former une zone de film contraint en compression (13).

3. Procédé selon la revendication 2, dans lequel les transistors à canal P sont réalisés dans la zone de film contrainte en compression (13).

4. Dispositif comprenant un substrat du type silicium sur isolant complétement déserté comportant un film semi-conducteur (1) disposé sur une couche isolante (2) dite enterrée elle-même disposée sur un substrat support de silicium non contraint (3), le film semi-conducteur comportant au moins une première zone de film (10) comportant du silicium contraint en tension et au moins une deuxième zone de film (12) comportant du silicium relâché en tension, au moins un transistor à canal N, NMOS, (TN) disposé dans et sur ladite au moins une première zone de film (10) et au moins un transistor à canal P, PMOS, (TP) disposé dans et sur ladite deuxième zone de film (12), ladite couche isolante enterrée (2) comportant au moins une ouverture sous ladite au moins une deuxième zone de film (12), ladite au moins une ouverture comportant une zone de silicium épitaxié non contraint (31), le dispositif étant **caractérisé en ce que** l'ouverture est formée au niveau d'un puits (81) destiné à permettre un contact avec le substrat support de silicium depuis la face supérieure du film (1), et **en ce que** des zones d'isolation (7) permettant d'isoler électriquement la première zone de film (10) et la deuxième zone de film (12) et de délimiter le puits (81).

## Patentansprüche

1. Verfahren zur Herstellung von Transistoren vom Typ mit N-Kanal und von Transistoren vom Typ mit P-Kanal, in einem Substrat vom Typ Silizium auf einem vollständig verarmten, ursprünglich verspannten Isolator, einen ursprünglich verspannten Halbleiterfilm (1) aus Silizium umfassend, der auf einer vergraben genannten isolierenden Schicht (2) angeordnet ist, die selbst auf einem nicht verspannten Silizium-Trägersubstrat (3) angeordnet ist, wobei das Verfahren eine lokalisierte Veränderung der Spannungen umfasst, Folgendes umfassend:
eine Bildung mindestens einer Öffnung (4) in dem ursprünglich verspannten Halbleiterfilm (1) aus Silizium und in der zugrundeliegenden vergrabenen isolierenden Schicht (2) bis zum Erreichen des nicht verspannten Silizium-Substrats (3) wobei die Öffnung (41) im Bereich einer Senke (81) gebildet ist, die dazu bestimmt ist, einen Kontakt mit dem Silizium-Trägersubstrat von der Oberseite des ursprünglich verspannten Halbleiterfilms (1) aus Silizium zu ermöglichen,
eine Silizium-Epitaxie (30) in der mindestens einen Öffnung (4) ausgehend von dem nicht verspannten Silizium-Trägersubstrat (3) um die mindestens eine Öffnung zu verschließen, die mindestens eine nicht verspannte epitaktische Silizium-Zone (31) bildet,
eine lokalisierte Amorphisierung einer Zone des ursprünglich verspannten Halbleiterfilms aus Silizium, die die mindestens eine nicht verspannte epitaktische Silizium-Zone (31) beinhaltet, die mindestens eine amorphisierte Zone (11) bildet und,
eine Rekristallisation der mindestens einen amorphisierten Zone (11) durch eine Festphasen-Epitaxie (50) ausgehend von dem Teil der mindestens einen nicht verspannten epitaktischen Silizium-Zone (31), die in der mindestens einen Öffnung gelegen, und in Kontakt mit der mindestens einen amorphisierten Zone (11) ist, um in dem ursprünglich verspannten Halbleiterfilm (1) aus Silizium mindestens eine lokalisierte Filmzone (12) zu erhalten, die spannungsgelöstes Silizium beinhaltet,
eine Herstellung von Isolierungszonen (7), um Zonen (10) des ursprünglich verspannten Halbleiterfilms (1) aus Silizium elektrisch zu isolieren, die verspanntes Silizium, und die mindestens eine lokalisierte Filmzone (12), die spannungsgelöstes Silizium beinhaltet, beinhalten, und um die Senke (81) zu begrenzen,
wobei das Verfahren weiter umfasst:
eine Herstellung der P-Kanal Transistoren in der mindestens einen spannungsbefreiten lokalisierten Silizium-Zone (12), und
eine Herstellung der N-Kanal Transistoren in den Zonen (10) des ursprünglich verspannten Halbleiterfilms (1) aus Silizium die verspanntes Silizium beinhalten.

2. Verfahren nach Anspruch 1, wobei die lokalisierte Veränderung der Spannungen weiter eine Bildung einer Silizium Germanium Legierung (13) in mindestens einem Teil der nicht verspannten lokalisierten Zone umfasst, um eine verspannte Film-Zone (13) zu bilden.

3. Verfahren nach Anspruch 2, wobei die P-Kanal Transistoren in der verspannten Film-Zone (13) hergestellt werden.

4. Vorrichtung, umfassend ein Substrat vom Typ Silizium auf einem vollständig verarmten Isolator, einen Halbleiterfilm (1) umfassend, der auf einer vergraben genannten isolierenden Schicht (2) angeordnet ist, die selbst auf einem nicht verspannten Silizium-Trägersubstrat (3) angeordnet ist, wobei der Halbleiterfilm mindestens eine erste Filmzone (10) beinhaltet, die verspanntes Silizium beinhaltet, und mindestens eine zweite Filmzone (12), die spannungsbefreites Silizium beinhaltet, mindestens einen N-Kanal Transistor, NMOS, (TN), der in und auf der mindestens einen ersten Filmzone (10) angeordnet ist, und mindestens einen P-Kanal Transistor, PMOS, (TP), der der in und auf der mindestens einen zweiten Filmzone (12) angeordnet ist, wobei die vergrabene isolierende Schicht (2) mindestens eine Öffnung unter der mindestens einen zweiten Filmzone (12) beinhaltet, wobei die mindestens eine Öffnung eine nicht verspannte epitaktische Silizium-Zone (31) beinhaltet, wobei die Vorrichtung **dadurch gekennzeichnet ist, dass** die Öffnung im Bereich einer Senke (81) gebildet ist, die dazu bestimmt ist, einen Kontakt mit dem Silizium-Trägersubstrat von der Oberseite des Films (1) zu ermöglichen, und dadurch, dass es Isolierungszonen (7) ermöglichen, die erste Filmzone (10) und die zweite Filmzone (12) elektrisch zu isolieren, und die Senke (81) zu begrenzen.

## Claims

1. Method for producing transistors of the N-channel type and transistors of the P-channel type in an initially tensilely stressed substrate of the fully depleted silicon on insulator type comprising an initially tensilely stressed silicon semiconductor film (1) disposed on a "buried" insulating layer (2) itself disposed on an unstressed silicon supporting substrate (3), the method comprising a localised modification of the stresses comprising:
a formation of at least one opening (4) in the initially stressed silicon semiconductor film (1) and in the underlying buried insulating layer (2) until the unstressed silicon substrate (3) has been reached, said opening (41) being formed at a well (81) intended to allow contact with the silicon supporting substrate from the upper face of the initially stressed silicon semiconductor film (1),
an epitaxy (30) of silicon in said at least one opening (4) starting from the unstressed silicon supporting substrate (3) in such a way as to fill said at least one opening, forming at least one zone of unstressed epitaxied silicon (31),
a localised amorphisation of a zone of said initially stressed silicon semiconductor film including said at least one zone of unstressed epitaxied silicon (31), forming at least one amorphised zone (11), and
a recrystallisation of said at least one amorphised zone (11) by a solid-phase epitaxy (50) starting from the part of said at least one zone of unstressed epitaxied silicon (31) located in said at least one opening and in contact with said at least one amorphised zone (11), in such a way as to obtain in the initially stressed silicon semiconductor film (1) at least one localised zone of film (12) including tensilely destressed silicon,
a production of insulation zones (7), in such a way as to electrically insulate zones (10) of the initially stressed silicon semiconductor film (1) including tensilely stressed silicon and said at least one localised zone of film (12) including tensilely destressed silicon and define said well (81),
the method further comprising:
a production of the P-channel transistors in said at least one localised zone of tensilely destressed silicon (12), and
a production of the N-channel transistors in the zones (10) of the initially stressed silicon semiconductor film (1) including tensilely stressed silicon.

2. Method according to claim 1, wherein said localised modification of the stresses further comprises a formation of an alloy of silicon-germanium (13) in at least a part of said tensilely destressed localised zone, in such a way as to form a zone of compressively stressed film (13).

3. Method according to claim 2, wherein the P-channel transistors are produced in the compressively stressed zone of film (13).

4. Device comprising a substrate of the fully depleted silicon on insulator type including a semiconductor film (1) disposed on a "buried" insulating layer (2) itself disposed on an unstressed silicon supporting substrate (3), the semiconductor film including at least one first zone of film (10) including tensilely stressed silicon and at least one second zone of film (12) including tensilely destressed silicon, at least one N-channel transistor, NMOS, (TN) disposed in and on said at least one first zone of film (10) and at least one P-channel transistor, PMOS, (TP) disposed in and on said second zone of film (12), said buried insulating layer (2) including at least one opening under said at least one second zone of film (12), said at least one opening including a zone of unstressed epitaxied silicon (31), the device being **characterised in that** the opening is formed at a well (81) intended to allow contact with the silicon supporting substrate from the upper face of the film (1), and **in that** insulation zones (7) allow to electrically insulate the first zone of film (10) and the second zone of film (12) and define the well (81).
